Europäisches Patentamt

European Patent Office

Office européen des brevets

(19)

(11) **EP 1 225 157 A1**

(12) **EUROPEAN PATENT APPLICATION**
published in accordance with Art. 158(3) EPC

(43) Date of publication:
24.07.2002 Bulletin 2002/30

(51) Int Cl.⁷: **C04B 35/00**

(21) Application number: 01912293.6

(86) International application number:
**PCT/JP01/01941**

(22) Date of filing: 13.03.2001

(87) International publication number:
**WO 01/68551 (20.09.2001 Gazette 2001/38)**

(84) Designated Contracting States:
**AT BE CH CY DE DK ES FI FR GB GR IE IT LI LU MC NL PT SE TR**

(30) Priority: 13.03.2000 JP 2000069018

(71) Applicant: **IBIDEN CO., LTD.**
**Ogaki-shi Gifu-ken 503-0917 (JP)**

(72) Inventors:
- **HIRAMATSU, Yasuji**
**Ibi-gun, Gifu 501-0695 (JP)**
- **ITO, Yasutaka**
**Ibi-gun, Gifu 501-0695 (JP)**

(74) Representative: **Gillard, Marie-Louise et al**
**Cabinet Beau de Loménie**
**158, rue de l'Université**
**75340 Paris Cédex 07 (FR)**

(54) **CERAMIC SUBSTRATE**

(57)    An object of the present invention is to provide an optimum ceramic substrate being excellent in temperature rising property and breakdown voltage and Young's modulus at a high temperature as a substrate for producing/examining a semiconductor, and in the ceramic substrate of the present invention having a conductor on a surface or inside thereof, the ceramic substrate has a leakage quantity of $10^{-7}$ Pa · m³ / sec (He) or less by measurement with a helium leakage detector.

**EP 1 225 157 A1**

**Description**

Field of the Invention

The present invention relates to a ceramic substrate used mainly in the semiconductor industry and more particularly to a ceramic substrate having a high breakdown voltage and being excellent in adsorptive function of a semiconductor wafer in the case of application to an electrostatic chuck, and simultaneously being excellent in the temperature rising/falling property in the case of application to a hot plate (a heater).

Background of the Invention

Semiconductors are significantly important products needed in various industries and a semiconductor chip is produced by slicing a silicon single crystal into a certain thickness to produce a silicon wafer and then forming a plurality of integrated circuits or the like on the silicon wafer.

In the production process of the semiconductor chip, a silicon wafer put on the electrostatic chuck is subjected to various treatments such as etching, CVD and the like to form conductor circuits, elements and the like. At that time, since corrosive gases are used as gases for deposition, gases for etching and the like, it is required to protect an electrostatic electrode layer from corrosion by these gases and it is also required to induce adsorptive force and therefore, the electrostatic electrode layer is generally coated with a ceramic dielectric film.

As the ceramic dielectric film, a nitride ceramic has conventionally been used and for example, in JP Kokai Hei 5-8140, an electrostatic chuck using nitride such as aluminum nitride is disclosed. Further, in JP Kokai Hei 9-48668, a carbon-containing aluminum nitride having an Al-O-N structure is disclosed.

Summary of the Invention

However, an electrostatic chuck using these ceramics has problems such as that: the temperature rising/falling property is insufficient; the breakdown voltages drops at high temperature; and warping occurs at high temperature owing to the drop of Young's modulus.

It has been understood that such problems are found not only in an electrostatic chuck but also in a ceramic substrate for a semiconductor producing/examining device wherein a conductor is formed on a surface or inside the ceramic substrate thereof such as a hot plate and a wafer prober.

Inventors of the present invention have made investigations to solve the above described problems and found that: causes of deterioration of the temperature rising/falling property and drop of the breakdown voltage and Young's modulus and the like of the ceramic substrate are due to the insufficient sintering property; and the above described problems can be solved by adjusting the degree of the sintering so as to lower the leakage quantity to $10^{-7}$ Pa $\cdot$ m$^3$ / sec (He) or less measured with a helium leakage detector. Practically, inventors have found that the leakage quantity can be suppressed to $10^{-7}$ Pa $\cdot$ m$^3$ / sec (He) or less, which is measured with the helium leakage detector, by at first oxidizing the surface of the raw material particles of a nitride ceramic, then adding an oxide and carrying out pressurized sintering, and thus completed the present invention.

In addition, inventors have also found that if the leakage quantity is $10^{-12}$ Pa $\cdot$ m$^3$ / sec (He) or less by measurement with the helium leakage detector, densification proceeds to an excess extent to result in a drop of the fracture toughness value and thermal conductivity at a high temperature, to the contrary.

That is, the present invention is a ceramic substrate having a conductor on a surface or inside thereof, wherein the ceramic substrate has a leakage quantity of $10^{-7}$ Pa $\cdot$ m$^3$ / sec (He) or less by measurement with a helium leakage detector.

Brief Description of Drawings

Fig. 1 is a plain view schematically showing an example of a ceramic heater using a ceramic substrate of the present invention.

Fig. 2 is a partially enlarged sectional view of the ceramic heater shown in Fig. 1.

Fig. 3 is a sectional view schematically showing an example of an electrostatic chuck using a ceramic substrate of the present invention.

Fig. 4 is a sectional view along the A-A line of the electrostatic chuck shown in Fig. 3.

Fig. 5 is a sectional view schematically showing an example of an electrostatic chuck using a ceramic substrate of the present invention.

Fig. 6 is a sectional view schematically showing an example of an electrostatic chuck using a ceramic substrate of the present invention.

Fig. 7 is a sectional view schematically showing an example of an electrostatic chuck using a ceramic substrate of the present invention.

Figs. 8(a) to (d) are sectional views schematically showing a part of manufacturing processes of an electrostatic chuck shown in Fig. 3.

Fig. 9 is a horizontal sectional view schematically showing a shape of an electrostatic electrode constituting an electrostatic chuck according to the present invention.

Fig. 10 is a horizontal sectional view schematically showing a shape of an electrostatic electrode constituting an electrostatic chuck according to the present invention.

Fig. 11 is a sectional view schematically showing a state that an electrostatic chuck according to the present invention is fitted in a supporting case.

Fig. 12 is a sectional view schematically showing a wafer prober using a ceramic substrate of the present invention.

Fig. 13 is a sectional view schematically showing a guard electrode of the wafer prober shown in Fig. 12.

Description of Reference Numerals

| | |
|---|---|
| 101, 201, 301, 401 | electrostatic chuck |
| 1 | ceramic substrate |
| 2, 22, 32a, 32b | chuck positive electrostatic layer |
| 3, 23, 33a, 33b | chuck negative electrostatic layer |
| 2a, 3a | semicircular arc part |
| 2b, 3b | combteeth-shaped part |
| 4 | ceramic dielectric film |
| 5, 12 | resistance heating element |
| 6, 13, 18 | external terminal |
| 7 | metal wire |
| 8 | Peltier device |
| 9 | silicon wafer |
| 11 | ceramic substrate |
| 14 | bottomed hole |
| 15 | through hole |
| 19 | conductor-filled through hole |
| 26 | lifter pin |

Detailed Description of the Invention

The present invention is a ceramic substrate having a conductor formed on a surface or inside thereof, wherein the ceramic substrate has a leakage quantity of $10^{-7}$ Pa $\cdot$ m$^3$ / sec (He) or less by measurement with a helium leakage detector.

The ceramic substrate of the present invention has the leakage quantity of $10^{-7}$ Pa $\cdot$ m$^3$ / sec (He) or less by measurement with the helium leakage detector. If the leakage quantity is in approximately such a degree, the above described ceramic substrate is sufficiently densely sintered and has excellent temperature rising/falling property, high breakdown voltage and Young's modulus at a high temperature. Consequently, no warping occurs in the above described ceramic substrate.

In case of measuring the above described leakage quantity, the sample same as the above described ceramic substrate is prepared to have a size of the diameter of 30 mm, the area of 706.5 mm$^2$ and the thickness of 1 mm, and set in the helium leakage detector. After that, the leakage quantity of the above described ceramic substrate can be measured by measuring a flow amount of helium passing through the above described sample. The helium leakage detector measures the partial pressure of helium at the time of the leakage but dose not measure the absolute value of the gas flow amount. The helium partial pressure values of known leakage quantities are previously measured and based on the detected helium partial pressure at the time of unknown leakage, the leakage quantity is calculated by simple proportional calculation.

The detailed measurement principle of the helium leakage detector is described in a monthly journal, "Semiconductor World 1992, November, p.112 to 115".

That is, if the above described ceramic substrate is sufficiently densely sintered, the above described leakage quantity is a considerably small value. On the other hand, if the sintering property of the above described ceramic substrate is insufficient, the above described leakage quantity becomes a large value.

In the present invention, for example, in case: the surface of a nitride ceramic particle is oxidized at first; then an oxide is added; and a pressurized sintering is carried out, a sintered body in which an oxide layer of the nitride ceramic is integrated with the added oxide is formed. Such a sintered body has an extremely small leakage quantity of $10^{-7}$ Pa $\cdot$ m$^3$ / sec (He) or less in the measurement with the helium leakage detector.

Still more, the leakage quantity is preferably $1 \times 10^{-12}$ to $1 \times 10^{-8}$ Pa $\cdot$ m$^3$ / sec (He) by measurement with the helium leakage detector. That is because a high thermal conductivity at a high temperature can be secured.

Incidentally, although aluminum nitride sintered bodies where a small amount of AlON crystal phase exists are disclosed in JP Kokai Hei 9-48668, JP Kokai Hei 9-48669, and JP Kokai Hei 10-72260 and the like, in these cases, no metal oxide is added and they are produced by reductive nitrogenation method. Therefore no oxygen exists on the surface and the sintering property is inferior. As shown in the comparative examples, a relatively high leakage quantity, approximately $10^{-6}$ Pa $\cdot$ m$^3$ / sec (He) , is caused. In JP Kokai Hei 7-153820, although yttria is added, the surface of an aluminum nitride raw material powder is not previously fired and in this case also, as it is made clear according to the comparative examples, the sintering properties are inferior and as shown in the comparative examples, a relatively high leakage quantity, approximately $10^{-6}$ Pa $\cdot$ m$^3$ / sec (He), is caused. In JP Kokai Hei 5-36819, electrostatic chucks using a sintered body produced from silicon nitride, yttria, and alumina are disclosed. However neither description nor implication of introducing oxygen in raw materials is disclosed and in this case also, a relatively high leakage quantity, approximately $10^{-6}$ Pa $\cdot$ m$^3$/sec (He) , is caused. Further, in JP Kokai Hei 10-279359, the leakage quantity is also high due to a low temperature and normal pressure firing. Furthermore, JP Kokai Hei 10-158002 discloses an AlN substrate used for a substrate on which a semiconductor is mounted but not for a semiconductor producing/examining device, unlike the present invention. Furthermore, in JP Kokai Hei 10-167859, since the amount of yttria is as small as 0.2 % by weight and sintering properties are insufficient, the leakage quantity becomes high. As described above, any conventional technique has not yet realized a semiconductor producing/examining device using a sintered body whose helium leakage quantity can be adjusted to $1 \times 10^{-7}$ Pa $\cdot$ m$^3$ / sec (He) or less just like the present invention.

It is also preferable that the oxide to be added is an oxide of an element constituting the nitride ceramics. That is because it is the same as the surface oxide layer of the nitride ceramic and makes the sintering considerably easy. In order to oxidize the surface of the nitride ceramic, it is preferable to carry out heating in oxygen or the air at 500 to 1,000 °C for 0.5 to 3 hours.

The average particle diameter of the nitride ceramic powder to be used for sintering is preferably approximately 0.1 to 5 μm. This is because it is easy to carry out sintering.

Further, the content of Si and the content of S are preferably 0.05 to 50 ppm and 0.05 to 80 ppm, respectively (both based on the weight) . That is because they are supposed to bond the added oxide with the oxide film on the nitride ceramic surface.

Other firing conditions will.be described in details in the description of electrostatic chuck manufacturing process later.

The ceramic substrate obtained by the firing according to the above described method is preferable to contain 0.05 to 10 % by weight of oxygen. That is because if it is less than 0.05 % by weight, sintering does not proceed, thus a fracture occurs in grain boundaries and the thermal conductivity is dropped. On the other hand, if it is higher than 10 % by weight, said oxygen is unevenly precipitated in the grain boundaries and a fracture in grain boundaries occurs and also the thermal conductivity is dropped to deteriorate the temperature rising/falling property.

In the present invention, the ceramic substrate is preferably made of an oxygen-containing nitride ceramic and the pore diameter of the maximum pores is preferably 50 μm or less and the porosity is preferably 5% or less. Further, preferably the above described ceramic substrate does not have pores at all, or if it has some pores, the pore diameter of the maximum pores is preferably 50 μm or less.

In case of the absence of pores, the breakdown voltage at a high temperature is especially raised. To the contrary, in the case that the pores are present, the fracture toughness value is raised. Therefore, which design should be selected is changed depending on the required properties.

Although the reason why the fracture toughness value is raised depending on the presence of the pores is not clear, it is supposed that the expansion of cracks is prevented by the pores.

The maximum pore diameter is preferable to be 50 μm or less in the present invention. This is because it becomes difficult to keep high breakdown voltage properties at a high temperature, especially at 200 °C or more, if the pore diameter exceeds 50 μm.

The pore diameter of the maximum pores is preferably 10 μm or less. That is because the degree of warping becomes small at 200°C or more.

The porosity and the pore diameter of the maximum pore can be adjusted by the duration for pressing, the pressure, the temperature at the time of sintering and the additives such as SiC and BN. Since SiC and BN inhibit sintering, they can introduce pores.

At the measurement of the pore diameter of the maximum pore, 5 samples are prepared. The surfaces thereof are ground into mirror planes. With an electron microscope, ten points on each surface are photographed with 2000 to 5000 magnifications. The maximum pore diameters is selected from each photogragh obtained by the photographing, and the average of the 50 shots is defined as the pore diameter of the maximum pore.

The porosity is measured by an Archimedes' method. A sintered body is pulverized, and then the pulverized pieces are put in an organic solvent or mercury to determine its volume. A true specific gravity is calculated from the weight and volume of the pulverized pieces and the porosity is calculated from the true specific gravity and an apparent specific gravity.

The diameter of the ceramic substrate of the present invention is preferably 200 mm or more. It is especially preferable to be 12 inches (300 mm) or more. That is because the ceramic substrate of this size is to be a main stream of a semiconductor wafer of the next generation. That is also because the problem of warping which the inventors of the present invention intend to solve hardly occurs if the ceramic substrate has 200 mm or less-diameter.

The thickness of the ceramic substrate of the present invention is preferably 50 mm or less and especially preferably 25 mm or less.

That is because, if the thickness exceeds 25 mm, the thermal capacity of the ceramic substrate sometimes becomes too large. Especially, in case of heating and cooling by a temperature control device which is provided, the temperature- following property is sometimes deteriorated due to the high thermal capacity.

Further, the problem of warping which the present invention intends to solve hardly occurs if the ceramic substrate has the thickness exceeding 25 mm.

Especially, the thickness of the ceramic substrate of the present invention is 5 mm or less optimally, and preferably to be 1 mm or more.

Further, the ceramic substrate of the present invention is used at 100 °C or more, preferably at 150°C or more, and especially preferably 200 °C or more.

Although the ceramic materials constituting the ceramic substrate of the present invention are not specifically limited, nitride ceramics and carbide ceramics are preferable. Examples of the above described nitride ceramics include metal nitride ceramics such as aluminum nitride, silicon nitride, boron nitride, titanium nitride and the like.

Also, examples of the above described carbide ceramics include silicon carbide, titanium carbide, tantalum carbide, tungsten carbide, zirconium carbide, and the like.

Further, as the above described ceramic materials, oxide ceramics may be used and the above described oxide ceramics include metal oxide ceramics such as alumina, zirconia, cordierite, mullite and the like.

Aluminum nitride is especially preferable among those nitride ceramics. That is because it has the highest thermal conductivity of 180 W / m · K.

In the present invention, it is preferable to contain an oxide in the ceramic substrate. As the above described oxide, for example, alkali metal oxide, alkaline earth metal oxide and rare earth oxide can be used, and $CaO$, $Y_2O_3$, $Na_2O$, $Li_2O$ and $Rb_2O$ are especially preferable in these sintering aids . Alumina and silica may also be used. The content of these compounds is preferably 0.5 to 20 % by weight. If lower than 0.5 % by weight, it is sometimes impossible to obtain the leakage amount of $10^{-7}$ Pa · $m^3$ / sec (He) or less.

As an oxide to be added, silica is the optimum in case of silicon nitride.

In the present invention, it is desirable to contain 5 to 5,000 ppm of carbon in the ceramic substrate.

That is because, by incorporating carbon, the ceramic substrate can be blackened and the radiation heat can be sufficiently utilized in the case of using the substrate for a heater.

The carbon may be either amorphous or crystalline. That is because: volume resistivity at a high temperature can be prevented from dropping in case where amorphous carbon is used; and the thermal conductivity at a high temperature is prevented from dropping in case where crystalline carbon is used. Consequently, based on the purposes of the use, both of crystalline carbon and amorphous carbon may be used together and the content of the carbon is further preferably 50 to 2,000 ppm.

When carbon is contained in the ceramic substrate, carbon is preferably contained in the manner that its brightness will be N6 or less as a value based on the rule of JIS Z 8721. The ceramic having such a brightness is superior in radiant heat capacity and hiding property.

The brightness N is defined as follows: the brightness of ideal black is made to 0; that of ideal white is made to 10; respective colors are divided into 10 parts in the manner that the brightness of the respective colors is recognized stepwise between the brightness of black and that of white at equal intensity intervals; and the resultant parts are indicated by symbols N0 to N10, respectively.

Actual brightness is measured by comparison with color chips corresponding to NO to N10. One place of decimals in this case is made to 0 or 5.

The ceramic substrate of the present invention is a ceramic substrate utilized for a device for producing a semiconductor or examining a semiconductor. As practical devices, for example, an electrostatic chuck, a wafer prober, a hot plate (a ceramic heater), a susceptor, and the like are included.

In case where the conductor formed inside the above described ceramic substrate is a resistance heating element, the ceramic substrate can be used as a ceramic heater (a hot plate).

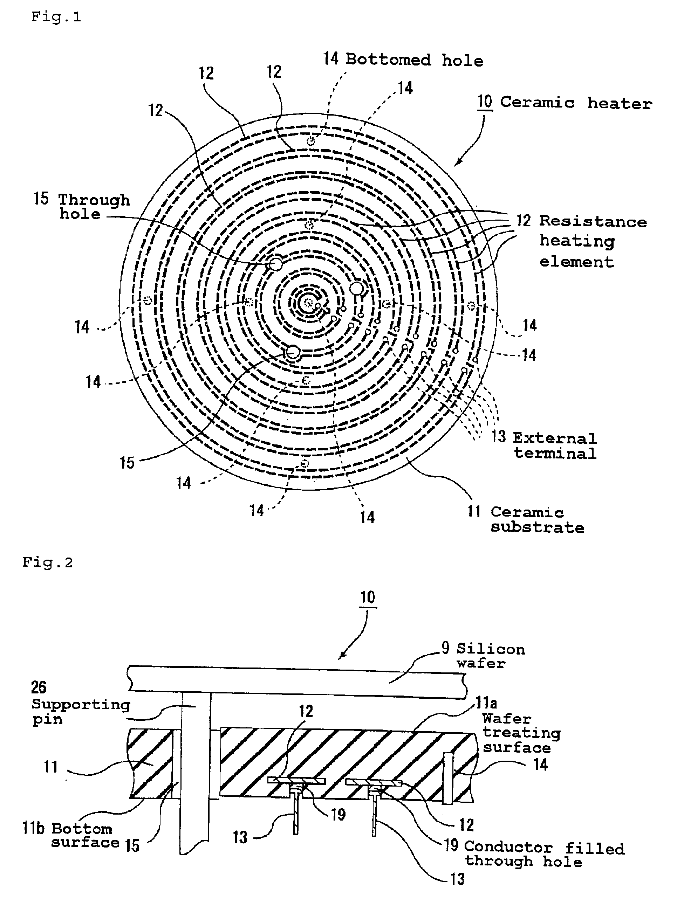

Fig. 1 is a plain view schematically showing an example of a ceramic heater, which is one embodiment of the ceramic substrate of the present invention. Fig. 2 is a partially enlarged sectional view of the ceramic heater shown in Fig. 1.

The ceramic substrate 11 is formed to be a circular shape and resistance heating elements 12, which are for a temperature controlling mean, are formed in concentric circular patterns inside the ceramic substrate 11. These resistance heating elements 12 are connected in the manner that two concentric circles near to each other, as a pair, are connected to produce one line. Each external terminal 13 to be the input and output terminals are connected to both end parts of the respective circuits through conductor-filled through holes 19.

As shown in Fig. 2, through holes 15 are also formed in the ceramic substrate 11 and lifter pins 26 are inserted into the through holes 15 to hold a silicon wafer 9.

By moving the lifter pins 26 up and down, it is possible to receive the silicon wafer 9 from a carrier machine, put the silicon wafer 9 on a wafer treating face 11a of the ceramic substrate 11, or heat the silicon wafer 9 while supporting it in the state that a gap of approximately 50 to 2,000 $\mu$m is kept between it and the wafer treating face 11a.

In addition, when: concave parts or through holes are formed in the ceramic substrate; and supporting pins with a tip of spire-shape or semispherical-shape are inserted into the concave parts or the through holes; and then a silicon wafer is supported by the supporting pins, the silicon wafer can be supported in the state of being kept at a distance approximately 50 to 2,000 $\mu$m from the heating surface, so as to be heated.

Bottomed holes 14 are formed in a bottom face 11b of the ceramic substrate 11 to insert a temperature measurement element such as a thermocouple and the like. When the resistance heating elements 12 is energized, the ceramic substrate 11 is heated, thereby heating an object to be heated such as the silicon wafer.

Since the ceramic substrate 11 constituting the hot plate has a leakage quantity as low as $10^{-7}$ Pa $\cdot$ m$^3$/sec (He) or less by measurement with a helium leakage detector, the ceramic substrate 11 is sufficiently densely sintered. Consequently, the ceramic substrate 11 is excellent in the temperature rising/falling property, and breakdown voltage and Young's modulus thereof does not dropped and no warping occurs in the ceramic substrate.

The resistance heating elements may be provided inside the ceramic substrate or may be provided on the bottom face of the ceramic substrate. In case of providing the resistance heating elements, an inlet for blowing a coolant such as air as a cooling mean may be formed in the supporting case to fit the ceramic substrate in. In the present invention, since gas does not leak, when the gas as a coolant is blown, the cooling speed can be increased.

If the resistance heating elements are provided inside the ceramic substrate, they may be provided in a plurality of layers. In this case, it is desirable that the patterns of the respective layers may be formed to complement them mutually. The pattern, when being viewed from the heating surface, is desirably formed on any one of the layers. For example, a structure having a staggered arrangement is desirable.

As the resistance heating elements, a sintered body of a metal or conductive ceramic, a metal foil, a metal wire, and the like is used. As the metal sintered body, at least one selected from tungsten and molybdenum is preferable. That is because these metals are relatively hard to be oxidized and have sufficient resistance values for heating.

Also, as the conductive ceramics, at least one selected from carbide of: tungsten; and molybdenum can be used.

In addition, in case of forming the resistance heating elements on the bottom face of the ceramic substrate, it is desirable to use noble metals (gold, silver, palladium or platinum) and nickel as the metal sintered body. Specifically, silver, silver-palladium and the like can be used.

As the metal particles used in the metal sintered body, particles of spherical or scaly particles, or a mixture of spherical particles and scaly particles can be used.

In case of forming the resistance heating elements on the ceramic substrate surface, a metal oxide is added to a metal for the sintering. The above described metal oxide is used in order to let the ceramic substrate closely adhere to particles of the metal. The reason why the adhesion between the ceramic substrate and the metal particles is improved by the metal oxide is unclear, but would be as follows: an oxide film is slightly formed on the surface of the metal particles and an oxide film is formed on the surface of the ceramic substrate in the case that the ceramic substrate is made of a non-oxide ceramic as well as an oxide ceramic. It can be therefore considered that these oxide films are sintered and integrated with each other, through the metal oxide, on the surface of the ceramic substrate so that the metal particles and the ceramic substrate adhere closely to each other.

As the above described metal oxide, at least one selected from such as lead oxide, zinc oxide, silica, boron oxide ($B_2O_3$), alumina, yttria and titania is preferable. These oxides make it possible to improve the adhesiveness between the metal particles and the ceramic substrate without increasing the resistance value of the resistance heating element.

The above described metal oxide is preferable to be added in an amount of 0.1 parts by weight or more and less than 10 parts by weight for 100 parts by weight of metal particles. That is because the adhesion strength of the metal particles and the ceramic substrate can be improved without too much rise of the resistance value by using the metal oxide within the range.

The ratio of lead oxide, zinc oxide, silica, boron oxide ($B_2O_3$), alumina, yttria and titania are also preferable to be: 1 to 10 parts by weight for lead oxide; 1 to 30 parts by weight for silica; 5 to 50 parts by weight for boron oxide; 20 to 70 parts by weight for zinc oxide; 1 to 10 parts by weight for alumina; 1 to 50 parts by weight for yttria; 1 to 50 parts by weight for titania, respectively, to 100 parts by weight in total of metal oxides. Nevertheless, the adjustment is preferably carried out in the ranges of not exceeding 100 parts by weight in the total. That is because, in these ranges, the adhesion to the ceramic substrate can be improved.

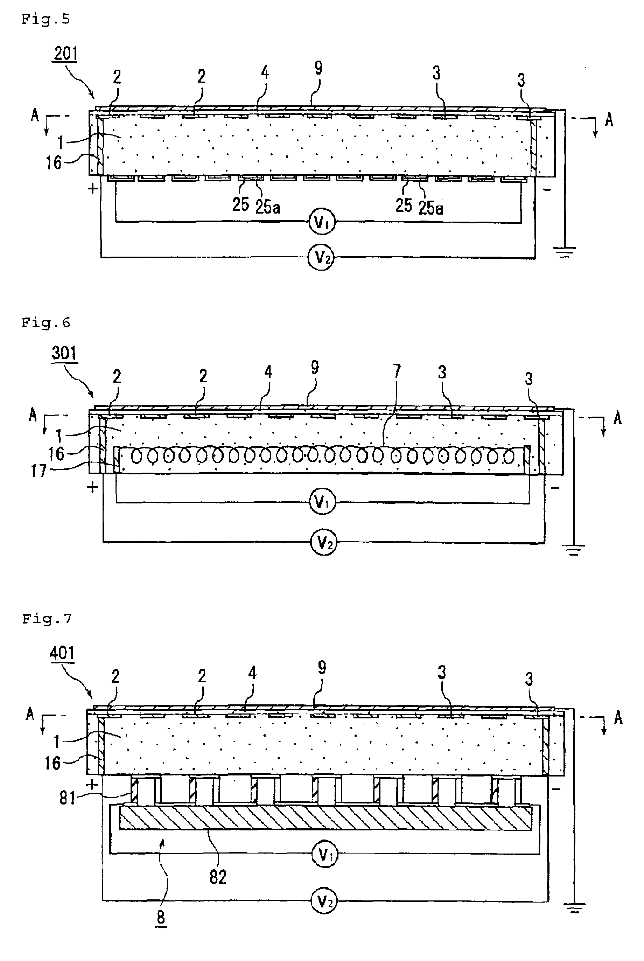

In case of providing the resistance heating elements on the bottom face of the ceramic substrate, it is desirable that the surface of the resistance heating elements 25 is coated with a metal layer 25a (reference to Fig. 5). The resistance heating elements 25 are a sintered body of metal particles and if being exposed, they are easy to be oxidized thus, due to the oxidation, the resistance values are possible to be changed by the oxidation . Therefore, the oxidation can be prevented by covering the surface with the metal layer 25a.

The thickness of the metal layer 25a is preferably 0.1 to 100 μm. That is because, this is the range where the oxidation of the resistance heating elements can be prevented without changing the resistance values of the resistance heating elements.

The metal used for covering may be a non-oxidative metal. Specifically, at least one selected from gold, silver, palladium, platinum and nickel is preferable. Especially, nickel is more preferable. That is because: the resistance heating elements are required to have terminals to connect themselves with an electric power, therein nickel can prevent the thermal diffusion of a solder which is employed for attaching terminals to the resistance heating elements. External terminals made of Kovar may be used as the connection terminals.

In case of forming the resistance heating elements inside the ceramic substrate, since the resistance heating elements surface is not oxidized, covering is not required. In case of forming the resistance heating elements inside a heater plate, a part of the surface of the resistance heating elements may be exposed.

Metal foils and metal wires may also be used as the resistance heating elements. As the above described metal foils, the resistance heating elements wherein a nickel foil and a stainless foil are patterned by etching or the like is desirable. The patterned metal foils may be stuck by a resin film or the like. As the metal wires, a tungsten wire, a molybdenum wire and the like are used.

If the conductor formed inside the above described ceramic substrate is an electrostatic electrode layer, the above described ceramic substrate may be used as an electrostatic chuck. In this case, RF electrodes and heating elements may be formed as a conductor under the electrostatic electrode in the ceramic substrate.

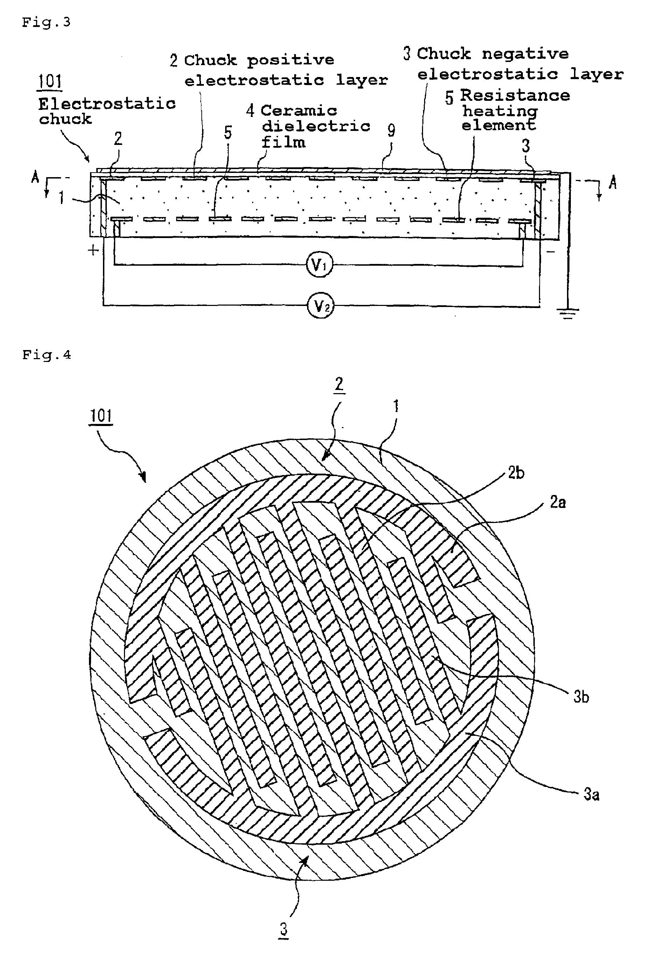

Fig. 3 is a longitudinal-sectional view schematically showing one embodiment of an electrostatic chuck according to the present invention, and Fig. 4 is a sectional view along the A-A line of the electrostatic chuck shown in Fig. 3.

In the electrostatic chuck 101, an electrostatic electrode layer comprising a chuck positive electrostatic layer 2 and a chuck negative electrostatic layer 3 are embedded inside the disk-shaped ceramic substrate 1, and a thin ceramic layer 4 (hereinafter referred to as a ceramic dielectric film) is formed on the electrostatic electrode layer. A silicon wafer 9 is put on the electrostatic chuck 101 and grounded.

As shown in Fig. 4, the chuck positive electrostatic layer 2 is composed of a semicircular arc part 2a and a combteeth-shaped part 2b and the chuck negative electrostatic layer 3 is also composed of a semicircular arc part 3a and a combteeth-shaped part 3b. These chuck positive electrostatic layer 2 and the chuck negative electrostatic layer 3 are so arranged face to face as to cross the combteeth-shaped parts 2b, 3b each other, and the positive side and the negative side of a direct current power source are respectively connected to the chuck positive electrostatic layer 2 and chuck negative electrostatic layer 3 to apply direct current voltage $V_2$.

The resistance heating elements 5 having a shape of concentric circles, as viewed from the above, are provided inside the ceramic substrate 1 in order to control the temperature of the silicon wafer 9 as shown in Fig. 1, and an external terminal is connected and fixed to both ends of the resistance heating elements 5 and a voltage $V_1$ is applied thereto. Although being not shown in Figs. 3, 4, as shown in Figs. 1, 2, a bottomed hole is formed to insert a temperature measuring element, and through holes into which lifter pins (not shown) for supporting and moving the silicon wafer 9 up and down are to be inserted, are also formed. Still more, the resistance heating elements may be formed on the bottom face of the ceramic substrate.

When the electrostatic chuck 101 is made to function, the direct current voltage $V_2$ is applied to the chuck positive electrostatic layer 2 and chuck negative electrostatic layer 3. Consequently, the silicon wafer 9 is adsorbed to these electrodes through the ceramic dielectric film 4 due to the electrostatic function of the chuck positive electrostatic layer 2 and the chuck negative electrostatic layer 3. In such a manner, after the silicon wafer 9 is fixed on the electrostatic chuck 101, the silicon wafer 9 is subjected to various treatments such as CVD and the like.

Regarding the above described electrostatic chuck 101, the ceramic dielectric film 4 is made of an oxygen-containing nitride ceramic and preferably has the porosity of 5% or less and the maximum pore diameter of 50 μm or

less. The pores in the ceramic dielectric film 4 are preferably formed to be independent pores each other.

Since the ceramic substrate constituting the electrostatic chuck has the leakage quantity as low as $10^{-7}$ Pa · $m^3$/sec (He) or less by measurement with the helium leakage detector, the ceramic substrate is sufficiently densely sintered. Consequently, the ceramic substrate is excellent in temperature rising/falling property, its breakdown voltage and Young's modulus does not drop, and no warping occurs in the ceramic substrate at a high temperature.

As the temperature control means, other than the resistance heating elements 12, a Peltier device (reference to Fig. 7) is available.

If the Peltier device is used as the temperature control means, it is advantageous since both of heating and cooling can be carried out by changing the direction of the current flow.

As shown in Fig. 7, the Peltier device 8 is formed by connecting p-type and n-type thermoelectric elements 81 in series and joining them to a ceramic plate 82 or the like.

As the Peltier device, for example, silicon-germanium type, bismuth-antimony type, lead-tellurium type materials are available.

The electrostatic chuck of the present invention has the constitution shown in Figs. 3, 4. The materials or the like of the ceramic substrate are already described and hereinafter, other members constituting the above described electrostatic chuck and other embodiments of the electrostatic chuck of the present invention will successively be described in details.

The materials for the ceramic dielectric film employed for the electrostatic chuck of the present invention are not restricted and may be carbide ceramics or oxide ceramics, but among them nitride ceramics are preferable.

As the above described nitride ceramics, the same as the above described ceramic substrate are available. The above described nitride ceramics desirably contain oxygen. In such a case, the nitride ceramics are easy to be sintered and even if the pores are included, the pores become independent pores, thus improves the breakdown voltage.

In order to incorporate oxygen in the above described nitride ceramics, firing is generally carried out after mixing a metal oxide with the raw material powders of the nitride ceramics.

Examples of the above described metal oxide are alumina ($Al_2O_3$) and silicon oxide ($SiO_2$).

The addition amounts of these metal oxides are preferably 0.5 to 10 parts by weight par 100 parts by weight of nitride ceramics.

By controlling the thickness of the ceramic dielectric film to be 50 to 5,000 $\mu$m, sufficiently high breakdown voltage can be kept without lowering chuck force.

If the thickness of the above described dielectric ceramic film is less than 50 $\mu$m, the film thickness is too thin and sufficiently high breakdown voltage cannot be obtained and therefore at the time when silicon wafer is put and adsorbed, insulating breakdown may occur in the ceramic dielectric film. On the other hand, if the thickness, of the above described dielectric ceramic film exceeds 5,000$\mu$m, the distance between silicon wafer and the electrostatic electrodes becomes too far and therefore the adsorbing capability of the electrodes to the silicon wafer is deteriorated. The thickness of the ceramic dielectric film is preferably 100 to 1,500 $\mu$m.

Also, if the above described porosity exceeds 5 %, the number of pores is increased and the pore diameter becomes too large and, as a result, the pores are easy to be interconnected each other. In a dielectric ceramic film with such a structure, the breakdown voltage drops.

In addition, in case the pore diameter of the maximum pores exceeds 50 $\mu$m, even if oxides exist in grain boundaries, the high breakdown voltage at high temperature cannot be kept. The porosity is preferably 0.01 to 3 % and the pore diameter of the maximum pore is preferably 0.1 to 10 $\mu$m. In a ceramic dielectric film with such a constitution, the leakage quantity is as low as $10^{-7}$ Pa · $m^3$/sec (He) or less by measurement with the helium leakage detector. Consequently, the ceramic dielectric film is sufficiently densely sintered and it does not occur that corrosive gases permeate the dielectric ceramic film and corrode the electrostatic electrodes.

It is preferable to incorporate carbon in 50 to 5,000 ppm in the above described ceramic dielectric film. That is because the electrode patterns formed in the electrostatic chuck can be hidden and high radiation heat can be obtained. Further, as the volume resistivity becomes lower, the adsorbing capability to silicon wafers becomes higher in a low temperature region.

Still more, the existence of the pores in the dielectric ceramic film is allowed to a certain extent in the present invention since the fracture toughness value can be raised, thereby improving thermal impact resistance.

As the above described electrostatic electrodes, for example, sintered bodies of metal or conductive ceramics, and metal foils are available. As the metal sintered bodies, at least one selected from tungsten and molybdenum is preferable. The metal foils are also preferable to be of the same materials as the metal sintered body. That is because these metals are relatively hard to be oxidized and have sufficient conductivity. On the other hand, as the conductive ceramics, at least one selected from carbides of: tungsten; and molybdenum is available.

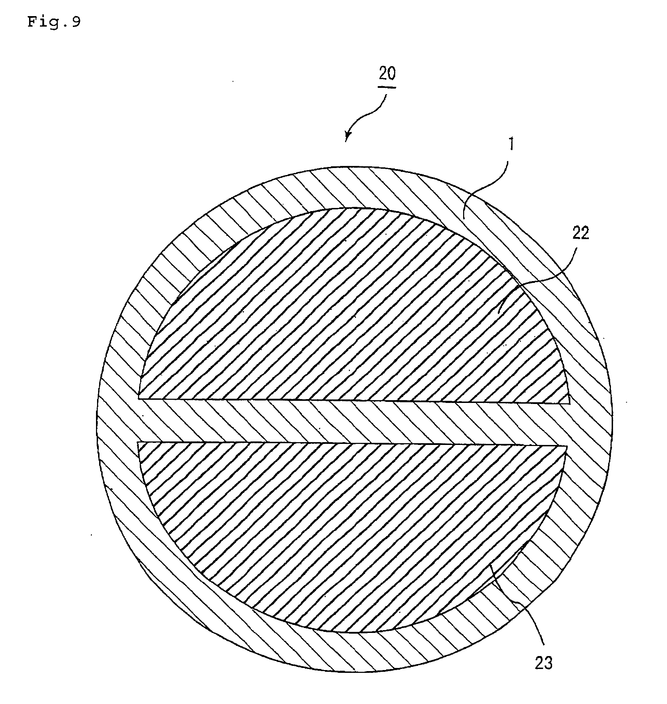

Figs. 9, 10 show horizontal sectional views schematically showing an electrostatic electrode in another electrostatic chuck. In the electrostatic chuck 20 shown in Fig. 9, semicircular chuck positive electrostatic layer 22 and chuck negative electrostatic layer 23 are formed inside the ceramic substrate 1, and in the electrostatic chuck shown in Fig. 10, chuck positive electrostatic layers 32a, 32b and chuck negative electrostatic layers 33a, 33b with a shape formed by dividing a circle into four are formed inside the ceramic substrate 1. Further, these two positive electrostatic layers 22a, 22b and two negative electrostatic layers 33a, 33b are so formed as to cross each other.

Still more, in case of forming electrodes having a shape in which a circular electrode is divided, the number of the division is not specifically restricted and may be five or more and the shape is also not restricted to a sector.

As the electrostatic chuck of the present invention, the followings are available for example: an electrostatic chuck 101 in which the chuck positive electrostatic layer 2 and the chuck negative electrostatic layer 3 are provided between the ceramic substrate 1 and the ceramic dielectric film 4, and the resistance heating elements 5 are provided inside the ceramic substrate 1 as shown in Fig. 3; an electrostatic chuck 201 in which the chuck positive electrostatic layer 2 and the chuck negative electrostatic layer 3 are provided between the ceramic substrate 1 and the ceramic dielectric film 4, and the resistance heating elements 25 are provided on the bottom face of the ceramic substrate 1 as shown in Fig. 5; an electrostatic chuck 301 in which the chuck positive electrostatic layer 2 and the chuck negative electrostatic layer 3 are provided between the ceramic substrate 1 and the ceramic dielectric film 4, and a metal wire 7 is embedded inside the ceramic substrate 1 as shown in Fig. 6; and an electrostatic chuck 401 in which the chuck positive electrostatic layer 2 and the chuck negative electrostatic layer 3 are provided between the ceramic substrate 1 and the ceramic dielectric film 4, and a Peltier device comprising a thermoelectric element 81 and a ceramic plate 82 is formed on the bottom face of the ceramic substrate 1 as shown in Fig. 7.

In the present invention, as shown in Figs. 3 to 7, since the chuck positive electrostatic layer 2 and the chuck negative electrostatic layer 3 are provided between the ceramic substrate 1 and the ceramic dielectric film 4, and the resistance heating elements 5 and the metal wire 7 are formed inside the ceramic substrate 1, connection parts (conductor-filled through holes) 16, 17 are required to connect them with external terminals. The conductor-filled through holes 16, 17 are formed by filling a high melting point metal such as a tungsten paste and a molybdenum paste, and a conductive ceramic such as tungsten carbide and molybdenum carbide.

The diameter of the connection parts (conductor-filled through holes) 16, 17 are preferably 0.1 to 10 mm. That is because cracking and strain can be prevented while preventing disconnection.

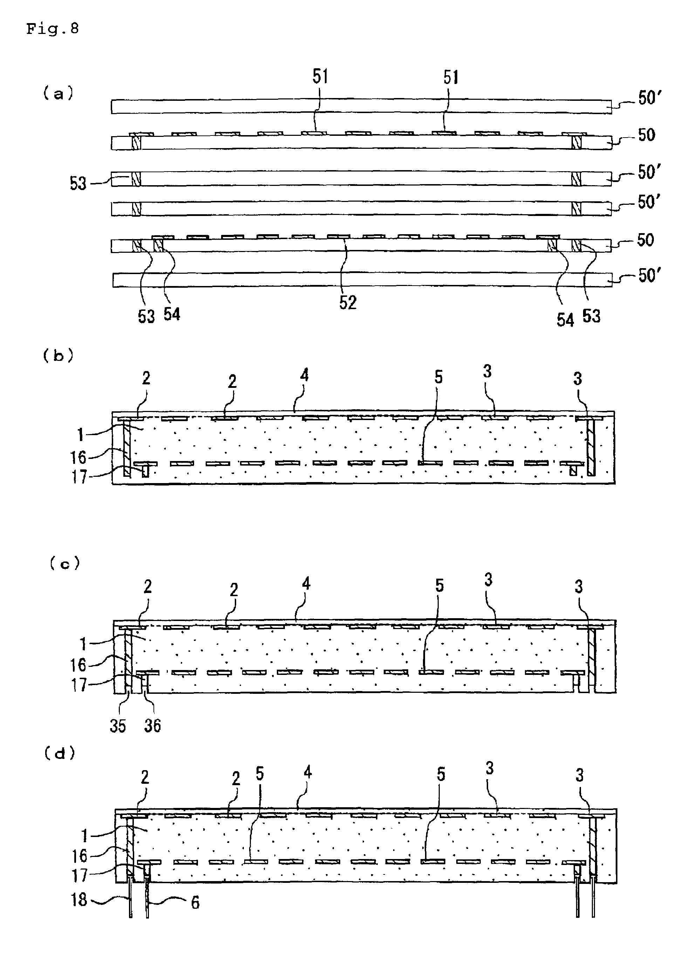

Using the conductor-filled through holes as connection pads, external terminals 6, 18 are connected (reference to Fig. 8(d)).

The connection is carried out by soldering or brazing. As the brazing material, silver brazing, palladium brazing, aluminum brazing, and gold brazing materials are used. As the gold brazing material, an Au-Ni alloy is preferable. That is because the Au-Ni alloy is excellent in adhesion with tungsten.

The Au/Ni ratio is preferably [81.5 to 82.5 (% by weight)] / [18.5 to 17.5 (% by weight)].

The thickness of the Au-Ni layer is preferably 0.1 to 50 $\mu$m. That is because the range is sufficient to keep the connection. Further, when being used at 500 to 1,000 °C in high vacuum of $10^{-6}$ to $10^{-5}$ Pa, a Au-Cu alloy is deteriorated, however the Au-Ni alloy is scarcely deteriorated and thus advantageous. Further, the amount of impurities in the Au-Ni alloy is preferably less than 1 parts by weight in case where the total quantity is set to be 100 parts by weight.

In the present invention, if necessary, a thermocouple may be buried in a bottomed hole of the ceramic substrate. That is because the temperature of the resistance heating elements can be measured by the thermocouple to control the temperature by changing the voltage and the electric current quantities based on the obtained data.

The size in the connection parts of the metal wires of the thermocouple is preferably either the same as that of the strand wire diameter of the each metal wire or larger than that, and 0.5 mm or less. With such a constitution, the thermal capacity of the connection parts is lowered and the temperature is precisely and quickly be converted to electric current values . Consequently, the temperature controllability is improved and the temperature distribution in the heating surface of the wafer is made small.

As the above described thermocouple, K type, R type, B type, S type, E type, J type and T type thermocouples are available as indicated in JIS-C-1602.

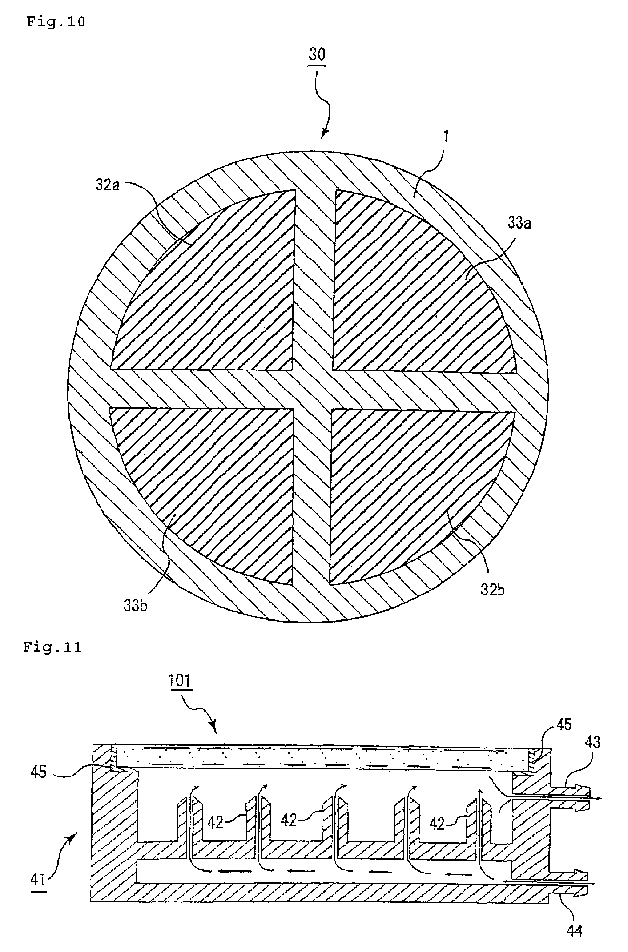

Fig. 11 is a sectional view schematically showing a supporting case 41 to fit the electrostatic chuck of the present invention with the above described structure.

The electrostatic chuck 101 is fitted in the supporting case 41 through a heat insulator 45. The supporting case 41 is provided with a coolant outlet 42. A coolant is blown therein from a coolant inlet 44 and discharged from a inhalation duct 43 through the coolant outlet 42. Due to the function of the coolant, the electrostatic chuck 101 is enabled be cooled.

Next, an example of a manufacturing process of one example of the electrostatic chucks using the ceramic substrate of the present invention will be described based on sectional views shown in Fig. 8(a) to (d).

(1) At first, a green sheet 50 is obtained by mixing a ceramic powder such as a nitride ceramic, carbide ceramic and the like with a binder and a solvent.

As the above described ceramic powder, for example, an oxygen-containing aluminum nitride powder obtained by firing it in oxidative atmosphere can be used. Further, if necessary, a sintering agent such as alumina and sulfur may be added.

Still more, since several or one green sheet 50' laminated on a green sheet on which an electrostatic electrode layer printed body 51 described below is formed is a layer to be the dielectric ceramic film 4, if necessary, it may have a composition different from that of the ceramic substrate.

Normally, as the raw materials of the ceramic dielectric film 4, it is preferable to use the same material as that of the ceramic substrate 1. That is because they are integrated and sintered together in many cases and the firing conditions are the same. However, in case where the materials are different, it may be possible: to produce the ceramic substrate at first; and to form an electrostatic electrode layer thereon; and then to form a ceramic dielectric film further thereon.

As the binder, at least one selected from acrylic binder, ethyl cellulose, butyl cellosolve, polyvinyl alcohol is desirable.

In addition, as the solvent, at least one selected from $\alpha$-terpineol and glycol is desirable.

The paste obtained by mixing them is formed to be a sheet-like shape by doctor blade method to produce the green sheet 50.

If necessary, the following may be provided in the green sheet 50: through holes for inserting lifter pins of the silicon wafer; a concave part for embedding the thermocouple; and a part where the conductor-filled through holes are formed. The through holes can be formed by punching and the like.

The preferable thickness of the green sheet 50 is approximately 0.1 to 5 mm.

Next, the through holes of the green sheet 50 are filled with the conductor containing paste to obtain conductor-filled through hole printed bodies 53, 54 and then the conductor containing paste to be the electrostatic electrode layers and resistance heating elements is printed on the green sheet 50.

The printing is so carried out as to obtain a desired aspect ratio in consideration of the shrinkage ratio of the green sheet 50, thereby obtaining an electrostatic electrode layer printed body 51 and a resistance heating element printed body 52.

The printed bodies can be formed by printing conductor containing pastes containing conductive ceramics and metal particles and the like.

As the conductive ceramic particles contained in the conductor containing pastes, a carbide of: tungsten; or molybdenum is optimum. That is because they are hardly oxidized and the thermal conductivity is hard to be lowered.

As the metal particles, tungsten, molybdenum, platinum, nickel and the like can be used.

The average particle diameter of the conductive ceramic particles and the metal particles is preferably 0.1 to 5 $\mu$m. That is because the conductor containing paste are difficult to be printed if the size is too large or too small.

As such a paste, the paste produced by the following is optimum; mixing 85 to 97 parts by weight of metal particles or conductive ceramic particles, 1.5 to 10 parts by weight of at least one binder selected from an acrylic type binder, ethyl cellulose, butyl cellosolve, and polyvinyl alcohol, and 1.5 to 10 parts by weight of at least one solvent selected from $\alpha$-terpineol, glycol, ethyl alcohol and butanol.

Next, as shown in Fig. 8(a), the green sheet 50 having the printed bodies 51, 52, 53, 54 and the green sheet 50' having no printed body are laminated. So as to prevent the end surfaces of the conductor-filled through holes from being exposed and oxidized at the time of firing of the resistance heating element formation, the green sheet 50' having no printed body is laminated on the resistance heating element formation side. If firing for the resistance heating elements formation is carried out with the end faces of the conductor-filled through holes exposed, it is required to sputter non-oxidizable metal such as nickel, or more preferably covering with a gold brazing material of Au-Ni may be carried out.

(2) Next, as shown in Fig. 8(b), the lamination is heated and pressurized to sinter the green sheets and the conductor containing pastes.

The heating temperature is preferably 1,700 to 2,000 °C and the pressure is preferably 100 to 200 kgf / cm². The heating and pressuring are carried out under the inert gas atmosphere. As the inert gas, argon, nitrogen and the like can be used. In the step, conductor-filled through holes 16, 17, the chuck positive electrostatic layer 2, the chuck negative electrostatic layer 3, resistance heating elements 5 and the like are formed.

(3) Next, as shown in Fig. 8(c), blind holes 35, 36 for external terminals connection are formed.

Inner walls of the blind holes 35, 36 are preferably at least partially made conductive and the inner walls, thus made conductive, are preferably connected with the chuck positive electrostatic layer 2, the chuck negative electrostatic layer 3, resistance heating elements 5 and the like.

(7) Finally, as shown in Fig. 8(d), external terminals 6, 18 are fitted in the blind holes 35, 36 through a gold brazing material. In addition, if necessary, a bottomed hole may be formed to bury a thermocouple inside thereof.

As a solder, alloys of silver-lead, lead-tin, bismuth-tin and the like can be used. Still more, the thickness of the solder layer is preferably 0.1 to 50 $\mu$m. That is because in this range it is sufficient to keep the connection by the solder.

Still more, although the above description is given taking the electrostatic chuck 101 as the example (reference to Fig. 3), in case of manufacturing the electrostatic chuck 201 (reference to Fig. 5) , after producing the ceramic plate having the electrostatic electrode layer, the conductor containing paste is printed and fired on the bottom face of the ceramic plate to form the resistance heating elements 25. After that, the metal layer 25a may be formed by an electroless plating or the like. On the other hand, in case of manufacturing the electrostatic chuck 301 (reference to Fig. 6) , a metal foil and a metal wire may be embedded in a ceramic powder as the electrostatic electrodes or the resistance heating elements, and then sintering is carried out.

In addition, in case of manufacturing the electrostatic chuck 401 (reference to Fig. 7), after a ceramic plate having electrostatic electrode layers is produced, a Peltier device is joined to the ceramic plate through a flame sprayed metal layer.

If conductors are provided on the surface and inside the ceramic substrate of the present invention; the conductor layer on the surface is a chuck top conductor layer; and the inner conductor is at least one of a guard electrode or a ground electrode , the above described ceramic substrate can function as a wafer prober.

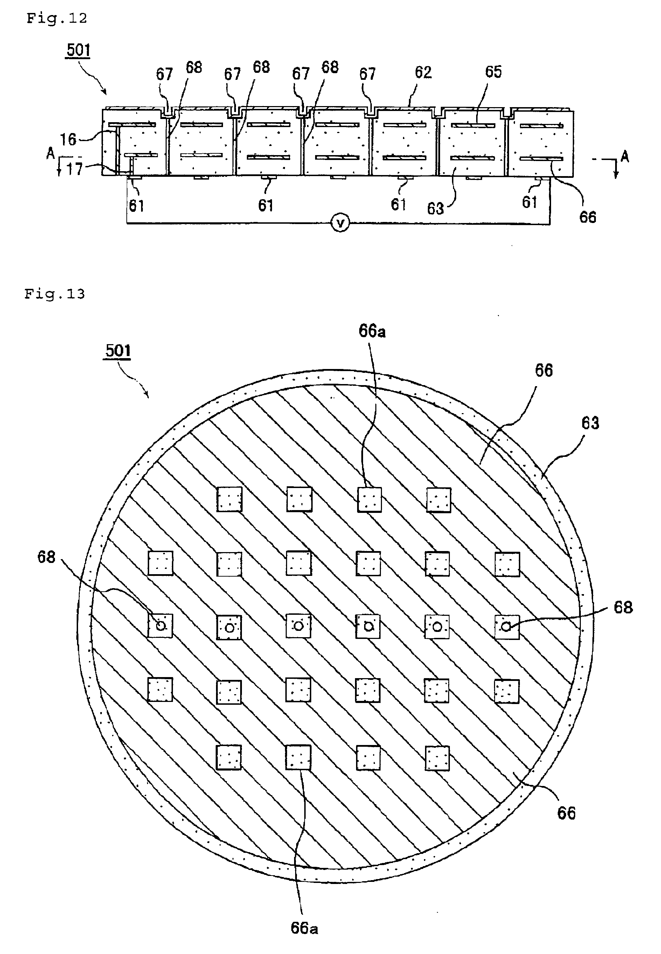

Fig. 12 is a sectional view schematically showing an embodiment of a wafer prober of the present invention and Fig. 13 is a sectional view along the A-A line of the wafer prober shown in Fig. 12.

In the wafer prober 501, grooves 67 having a shape of concentric circles, as viewed from the above, are formed on a surface of a disk-shaped ceramic substrate 63, simultaneously, a plurality of suction holes 68 for sucking the silicon wafer are provided to a part of the grooves 67, and the chuck top conductor layer 62 for connecting to electrodes of the silicon wafer, which is in circular shape, is formed in the most part of the ceramic substrate 63 including the grooves 67.

On the other hand, in order to control a temperature of the silicon wafer, heating elements 61 having shape of concentric circles, as viewed from the above, as shown in Fig. 1 are provided on the bottom face of the ceramic substrate 63, and external terminals (not shown) are connected and fixed to both ends of the heating elements 61. Also, in order to remove stray capacitor and noise, guard electrodes 65 and ground electrodes 66 (reference to Fig. 13) having a lattice-shape, as viewed from the above, respectively, are provided inside the ceramic substrate 63. The materials for the guard electrode 65 and the ground electrodes 66 may be the same as those of the electrostatic electrodes.

The thickness of the above described chuck top conductor layer 62 is desirably 1 to 20 $\mu$m. In case of less than 1 $\mu$m, the resistance value becomes too high and the layer does not function as an electrode and on the other hand, in case of exceeding 20 $\mu$m, it is easy to be peeled by stress which the conductor has.

As the chuck top conductive layer 62, at least one metal selected from high melting point metals such as copper, titanium chromium, nickel, noble metals (gold, silver, platinum and the like), tungsten and molybdenum can be used.

In the wafer prober having such a structure, after a silicon wafer on which an integrated circuit is formed is put, a probe card having tester pins is pushed against the silicon wafer and a voltage is applied while the silicon wafer being heated or cooled to carry out an electric continuity test. The ceramic substrate constituting such a wafer prober also has the leakage quantity of $10^{-7}$ Pa · m$^3$ / sec (He) or less by measurement with the helium leakage detector. Such a ceramic substrate is sufficiently densely sintered, and this wafer prober is excellent in temperature rising/falling property, the breakdown voltage and Young's modulus does not drop at a high temperature, and no warping occurs in the wafer prober.

Still more, in case of manufacturing the wafer prober, for example, in the same manner as that of the electrostatic chuck, at first a ceramic substrate in which the resistance heating elements are embedded is produced; and then the grooves are formed in the surface of the ceramic substrate; and successively a metal layer may be formed on the surface part where grooves are formed, by sputtering, plating or the like.

Best Modes for Carrying Out the Invention

Hereinafter, the present invention will be described more specifically.

(Examples 1 to 7) Manufacture of the electrostatic chuck 101 (reference to Fig. 3)

(1) A green sheet of 0.47 mm-thickness was obtained using a paste produced by mixing 1,000 parts by weight of an aluminum nitride powder (the average particle diameter of 0.6 $\mu$m, produced by Tokuyama Corp.) fired at 500 °C for 1 hour in the air, 40 parts by weight of yttria (the average particle diameter of 0.4 $\mu$m), 115 parts by weight of an acrylic binder, 5 parts by weight of a dispersant, and 530 parts by weight of alcohol containing 1-butanol and ethanol and then; by forming the paste by doctor blade method.

(2) Next, the green sheet was dried at 80 °C for 5 hours and then, parts to be through holes for inserting semiconductor wafer lifter pins having 1.8 mm, 3.0 mm and 5.0 mm in diameter; and parts to be conductor-filled through holes for connecting the external terminals were formed by punching.

(3) A conductor containing paste A was prepared by mixing 100 parts by weight of tungsten carbide particle having the average particle diameter of 1 $\mu$m, 3.0 parts by weight of an acrylic binder, 3.5 parts by weight of an $\alpha$-terpineol solvent, and 0.3 parts by weight of a dispersant.

A conductor containing paste B was prepared by mixing 100 parts by weight of tungsten particle having the average particle diameter of 3 $\mu$m, 1.9 parts by weight of an acrylic binder, 3.7 parts by weight of an $\alpha$-terpineol solvent, and 0.2 parts by weight of a dispersant.

The conductor containing paste A was printed on the green sheet by screen printing to form the conductor containing paste layer. The printing patterns are made to be concentric patterns . A conductor containing paste layer having the electrostatic electrode pattern with the shapes shown in Fig. 4 was also formed in another green sheet.

Further, the through holes for conductor-filled through holes for connecting external terminals were filled with the conductor containing paste B.

On the green sheet 50 on which the above described treatment was finished, 34 green sheets 50' on which no tungsten paste was printed were laminated on the upper side (the heating face) and 13 green sheets 50' on which no tungsten paste was printed were laminated on the lower side, respectively. Further, the green sheet 50 on which conductor containing paste layer of the electrostatic electrode patterns was printed was laminated thereon and furthermore, 2 green sheets 50', on which no tungsten paste was printed, were laminated and the resulting body was pressed to be integrated each other at 130 $°$C and 80 kgf/cm$^2$-pressure to obtain a lamination [Fig. 8(a)].

(4) Next, the obtained lamination was degreased at 600 $°$C for 5 hours in nitrogen gas and hot pressed at 1,890 $°$C for 3 hours under a pressure of 0 to 200 kgf/cm$^2$ as shown in Table 1 to obtain an aluminum nitride plate-shaped body with the thickness of 3 mm. It was cut in a disk-shaped piece having 230 mm-thickness to obtain a plate-shaped body made of an aluminum nitride and comprising resistance heating elements 5 having the thickness of 6 $\mu$m and the width of 10 mm, and the chuck positive electrostatic layer 2 and the chuck negative electrostatic layer 3 having the thickness of 10 $\mu$m inside thereof [Fig. 8(b)].

(5) Next, after grinding the plate-shaped body obtained in (4) by a diamond grind stone, a mask was put and bottomed holes (the diameter: 1.2 mm, the depth: 2.0 mm) were provided in the surface for a thermocouple by blast treatment by SiC and the like.

(6) Further, blind holes 35, 36 were formed by boring the parts where the conductor-filled through holes were formed [Fig. 8(c)] and external terminals 6, 18 made of Kovar were connected to the blind holes 35, 36 by using a gold brazing material of Ni-Au and carrying out heat reflow at 700 $°$C [Fig. 8(d)]. Still more, connection of the external terminals is desirable to have a structure wherein a support of tungsten supports at three points. That is because the connection reliability can be assured.

(7) Next, a plurality of thermocouples were buried in the bottomed holes for temperature control to complete the manufacture of the electrostatic chuck 101 having the resistance heating elements 5.

The breakdown voltage, the thermal conductivity, the degree of warping, the oxygen content, the leakage quantity, and the fracture toughness value were measured for the ceramic substrate (the ceramic dielectric film) of the thus manufactured electrostatic chuck 101 having the resistance heating elements 5, in the following method. The results were shown in the following Table 1.

(8) Next, the electrostatic chuck 101 was fitted in a supporting case 41 made of a stainless steel having the sectional shape of Fig. 11 through a heat insulating material 45 comprising a ceramic fiber (trade name: Ibiwool produced by Ibiden Co., Ltd.). The supporting case 41 had a coolant outlet 42 for a cooling gas to be capable of adjusting the temperature of the electrostatic chuck 101.

The resistance heating elements 5 of the electrostatic chuck 101 fitted in the supporting case 41 are energized to rise the temperature and a coolant was passed through the supporting case to control the temperature of the electrostatic chuck 101, it was found the temperature was able to be controlled extremely excellently. Further, the cooling time of the electrostatic chuck was measured according to the following method. The results were shown in Table 1.

(Example 8) Manufacture of the electrostatic chuck 201 (reference to Fig. 5)

(1) A green sheet of 0.47 mm-thickness was obtained: using a paste produced by mixing 1,000 parts by weight of an aluminum nitride powder (the average particle diameter of 0.6 $\mu$m, produced by Tokuyama Corp.) fired at 500 $°$C for 1 hour in the air, 40 parts by weight of yttria (the average particle diameter: 0.4 $\mu$m), 115 parts by weight of an acrylic binder, 5 parts by weight of a dispersant, and 530 parts by weight of alcohol containing 1-butanol and ethanol; and then forming the paste by doctor blade method.

(2) Next, the green sheet was dried at 80 $°$C for 5 hours and then, parts to be through holes for inserting semiconductor wafer lifter pins having a diameter of 1.8 mm, 3.0 mm and 5.0 mm, respectively, and parts to be conductor-filled through holes for connecting the external terminals were formed by punching.

(3) A conductor containing paste A was prepared by mixing 100 parts by weight of tungsten carbide particle having the average particle diameter of 1 μm, 3.0 parts by weight of an acrylic binder, 3.5 parts by weight of an α-terpineol solvent, and 0.3 parts by weight of a dispersant.

A conductor containing paste B was prepared by mixing 100 parts by weight of tungsten particle having the average particle diameter of 3 μm, 1.9 parts by weight of an acrylic binder, 3.7 parts by weight of an α-terpineol solvent, and 0.2 parts by weight of a dispersant.

The conductor containing paste A was printed on the green sheet by screen printing to form the conductor containing paste layer of the electrostatic electrode patterns having the shapes shown in Fig. 10.

Further, the through holes for conductor-filled through holes for connecting external terminals were filled with the conductor containing paste B.

On the green sheet 50 on which the above described treatment was finished, one green sheet 50' on which no tungsten paste was printed was laminated on the upper side (the heating face), and 48 green sheets 50' on which no tungsten paste was printed were laminated on the lower side, respectively, and the resulting body was pressed to be integrated each other at 130 °C and 80 kgf/cm²-pressure to form a lamination.

(4) Next, the obtained lamination was degreased at 600 °C for 5 hours in nitrogen gas and hot pressed at 1,890 °C for 3 hours under a pressure of 200 kgf / cm² to obtain an aluminum nitride plate-shaped body having the 3 mm-thickness. It was cut in a disk-shaped piece having 230 mm-thickness to obtain a plate-shaped body made of an aluminum nitride and comprising the chuck positive electrostatic layer 2 and the chuck negative electrostatic layer 3 having 15 μm-thickness inside thereof.

(5) Next, a mask was put on an opposite surface of the disk-shaped body obtained from above described (4) to provide concave parts (not shown) for the thermocouples on a surface thereof by blast treatment with SiC or the like.

(6) Next, the resistance heating elements 25 were printed on the face (the bottom face) opposite to the wafer putting face. A conductor containing paste was used for the printing. The used conductor containing paste was Solbest PS 603D produced by Tokuriki Kagaku Kenkyuusho Co., Ltd., which is commonly used for plated through hole formation of a printed circuit board. The conductor containing paste was a silver/lead paste and contained 7.5 parts by weight of metal oxides comprising lead oxide, zinc oxide, silica, boron oxide, and alumina (each weight ratio thereof was 5 / 55 / 10 / 25 / 5) in 100 parts by weight of silver. Further, the shape of the silver was scaly having the average particle diameter of 4.5 μm.

(7) The plate-shaped body on which the conductor containing paste was printed was heated and fired at 780 °C to sinter the silver and lead in the conductor containing paste, and simultaneously to bake it on the ceramic substrate. The plate-shaped body was further immersed in an electroless nickel plating bath of an aqueous solution containing 30 g / l of nickel sulfate, 30 g / l of boric acid, 30 g / l of ammonium chloride and 60 g / l of Rochelle salt to deposit a nickel layer 25a containing not more than 1 % by weight of boron and having 1 μm-thickness on the surface of the silver sintered body 15. After that, the plate-shaped body was annealed at 120 °C for 3 hours.

The resistance heating elements comprising the silver sintered body had 5 μm-thickness, 2.4 mm-width, and 7.7 mΩ / □ of surface resistivity.

(8) Next, blind holes were provided in the ceramic substrate for exposing the conductor-filled through holes 16. External terminal pins made of Kovar were connected to the blind holes by employing a gold brazing material comprising a Ni-Au (81.5 % by weight of Au, 18.4 % by weight of Ni, and 0.1 % by weight of impurities) and carrying out heat reflow at 970 °C. Further, external terminal pins made of Kovar were formed on the resistance heating elements using a solder (tin 9 / lead 1).

(9) Next, a plurality of thermocouples were buried in the concave parts for temperature control to obtain the electrostatic chuck 201.

The breakdown voltage, the thermal conductivity, the degree of warping, the oxygen content, the leakage quantity and the fracture toughness value of the ceramic substrate (the ceramic dielectric film) of the thus manufactured electrostatic chuck 201 having the resistance heating elements 5 are measured by the following method. The results were shown in the following Table 1.

(10) Next, the electrostatic chuck 201 was fitted in the supporting case 41 made of a stainless steel having the sectional shape shown in Fig. 11 through a heat insulating material 45 comprising a ceramic fiber (trade name: Ibiwool produced by Ibiden Co., Ltd.). The supporting case 41 had a coolant outlet 42 for a cooling gas, to be capable of adjusting the temperature of the electrostatic chuck 201.

The resistance heating elements 15 of the electrostatic chuck 201 fitted in the supporting case 41 was energized to rise the temperature and a coolant was also passed through the supporting case to control the temperature of the electrostatic chuck 201, it was found that the temperature was able to be controlled extremely excellently. Further, the cooling time of the electrostatic chuck was measured according to the following method. The results were shown in Table 1.

(Example 9) Manufacture of the electrostatic chuck 301 (Fig. 6)

(1) Two electrodes having the shape shown in Fig. 9 were formed by punching a tungsten foil having the thickness of 10 μm.

Together with the two electrode sheets and a tungsten wire, 1,000 parts by weight of an aluminum nitride powder (the average particle diameter of 1.1 μm, manufactured by Tokuyama Corp.) fired at 500 °C in the air, 40 parts by weight of yttria (the average particle diameter: 0.4 μm), and 115 parts by weight of an acrylic binder were put in a molding die and hot pressed at 1,890 °C for 3 hours under pressure of 200 kgf / cm$^2$ to obtain an aluminum nitride plate-shaped body having the thickness of 3 mm. It was cut into a disk-shaped piece having the diameter of 230 mm to obtain a plate-shaped body made of aluminum nitride. At that time, the thickness of the electrostatic electrode layer was 10 μm.

(2) The processes of (5) to (7) of the example 1 were carried out for the plate-shaped body to obtain the electrostatic chuck 301.

The breakdown voltage, the thermal conductivity, the degree of warping, the oxygen content, the leakage quantity, and the fracture toughness value of the ceramic substrate (the ceramic dielectric film) of the thus manufactured electrostatic chuck 301 having the resistance heating elements 5 were measured by the following methods. The results were shown in the following Table 1.

Further, the electrostatic chuck 301 was fitted in a supporting case in the same manner as the step (8) of the example 1 and the cooling time of the electrostatic chuck was measured by the following method. The results were shown in Table 1.

(Example 10) Manufacture of the electrostatic chuck 401 (Fig. 7)

After carrying out the processes (1) to (5) of the example 8, a nickel was further flame-sprayed on the bottom face, and then the electrostatic chuck 401 was obtained by joining lead-tellurium based Peltier devices.

The breakdown voltage, the thermal conductivity, the degree of warping, the oxygen content, the leakage quantity and the fracture toughness value of the ceramic substrate (the ceramic dielectric film) of the thus manufactured electrostatic chuck 401 having the resistance heating elements 5 were measured by the following method. The results were shown in the following Table 1. The electrostatic chuck 401 manufactured in such a manner was excellent in the temperature falling property and when being cooled by the Peltier devise, the electrostatic chuck 401 was cooled from 450 °C to 100 °C in 3 minutes.

The electrostatic chuck 301 was also fitted in a supporting case in the same manner as the step (10) of the example 8 and the cooling time was measured by the following method. The results were shown in Table 1.

(Comparative example 1) Manufacture of an electrostatic chuck

An electrostatic chuck was manufactured in the same manner as that of the example 1, except that a green sheet of 0.47 mm-thickness was obtained from a paste produced by mixing 1,000 parts by weight of an aluminum nitride powder (the average particle diameter of 1.1 μm, produced by Tokuyama Corp.), 40 parts by weight of yttria (the average particle diameter: 0.4 μm), 115 parts by weight of an acrylic binder, 5 parts by weight of a dispersant, and 530 parts by weight of alcohol containing 1-butanol and ethanol then by forming the paste by doctor blade method.

The breakdown voltage, the thermal conductivity, the degree of warping, the oxygen content, the leakage quantity, and the fracture toughness value of the ceramic substrate (the ceramic dielectric film) of the thus manufactured electrostatic chuck having the resistance heating elements 5 were measured by the following method. The results were shown in Table 1. Further, the electrostatic chuck was fitted in a supporting case in the same manner as that in the example 1 and the cooling time was measured by the following method. The results were shown in Table 1.

(Comparative example 2) Manufacture of an electrostatic chuck

An electrostatic chuck was manufactured in the same manner as that of the example 1, except that a green sheet of 0.47 mm-thickness was obtained from a paste produced by mixing 1,000 parts by weight of an aluminum nitride powder (the average particle diameter of 1.1 μm, produced by Tokuyama Corp.), 115 parts by weight of an acrylic binder, 5 parts by weight of a dispersant, and 530 parts by weight of alcohol containing 1-butanol and ethanol, and then by forming the paste by doctor blade method.

The breakdown voltage, the thermal conductivity, the degree of warping, the oxygen content, the leakage quantity, and the fracture toughness value of the ceramic substrate (the ceramic dielectric film) of the thus manufactured electrostatic chuck having the resistance heating elements 5 were measured by the following method. The results were shown in Table 1. Further, the electrostatic chuck was fitted in a supporting case in the same manner as that in the example 1 and the cooling time was measured by the following method. The results were shown in Table 1.

Evaluation method

(1) Evaluation of the breakdown voltage of a ceramic substrate (a ceramic dielectric film)

For the electrostatic chucks manufactured in the examples 1 to 10 and comparative examples 1,2, a metal electrode is put on the electrostatic chuck, a voltage is applied between the electrostatic electrode layer and the electrode, and a voltage at which the insulating breakdown occurs is measured.

(2) Thermal conductivity

a. An equipment to be employed
Rigaku-laser flash method thermal constant measurement equipment
LF/TCM-FA8510B
b. Testing conditions
temperature...25 °C, 450 °C
ambient condition...vacuum
c. Measurement method
The temperature detection in the specific heat measurement was carried out by using a thermocouple (Platinel) bonded to the back face of each sample by a silver paste.
The normal temperature specific heat measurement is carried out by further adhering a light receiving plate (glassy carbon) to the upper face of each sample by silicon grease and the specific heat (Cp) of each sample is calculated according to the following calculation equation (1):

$$Cp = \left\{ \frac{\Delta O}{\Delta T} - Cp_{G.c} \cdot W_{G.c} - Cp_{S.G} \cdot W_{S.G} \right\} \frac{1}{W} \quad \cdots \quad (1)$$

In the above described calculation equation (1) , $\Delta O$ represents the input energy, $\Delta T$ represents the saturation value of the temperature rise of each sample, $Cp_{GC}$ represents the specific heat of the glassy carbon, $W_{GC}$ represents the weight of the glassy carbon, $Cp_{SG}$ represents the specific heat of the silicon grease; $W_{SG}$ represents the weight of the silicon grease, and W represents the weight of each sample.

(3) The degree of warping

After heating to 450 °C and loading the weight of 150 kg/cm$^2$, each sample was cooled to 25 °C and the degree of warping was measured by using a shape measuring device (Nanoway manufactured by KYOCERA Co.).

(4) The oxygen content

Samples sintered in the same conditions as those for the sintered bodies of the examples and the comparative examples were pulverized in a tungsten mortar and 0.01 g of each pulverized sample was measured by the measurement using an oxygen/nitrogen determinator (TC-136 model manufactured by LECO Co.)in the conditions of: heating temperature at 2200 °C; and heating duration for 30 seconds.

(5) The leakage quantity

Using samples (area: 706.5mm$^2$, thickness: 1 mm) sintered in the same conditions as those for the sintered bodies of the examples and the comparative examples, the leakage quantity was measured by a general purpose type helium leakage detector (MSE-11AU/TP model manufactured by Shimadzu Co.)

(6) The fracture toughness value

An indentator was pressed onto the surface by a Vickers hardness meter (MVK-D model manufactured by Akashi Seisakusho Co.) and the length of formed cracks was measured and, then the calculation was performed based on the calculation equation (2) by using the measured value:

$$\text{Fracture toughness value} = 0.026 \times E^{1/2} \times 0.5 \times P^{1/2} \times a \times C^{-3/2} \qquad (2)$$

In the above described calculation equation (2), E represents Young's modulus ($3.18 \times 10^{11}$ Pa), P represents the pressing load (98 N), "a" represents a half (m) of the average length of the diagonal lines of indentation, C represents a half (m) of the average of the length of the cracks.

(7) The cooling time

The time taken to cool thereof to 100 °C by blowing air at 10 l/min after heating to 150 °C was measured.

(Example 11) Manufacture of the wafer prober 501 (reference to Fig. 11)

(1) A green sheet of 0.47 mm-thickness was obtained by employing a paste produced by mixing 1,000 parts by weight of an aluminum nitride powder (the average particle diameter of 1.1 μm, produced by Tokuyama Corp.), 40 parts by weight of yttria (the average particle diameter: 0.4 μm), 115 parts by weight of an acrylic binder, 0.002 parts by weight of boron nitride, 5 parts by weight of a dispersant, and 530 parts by weight of alcohol containing 1-butanol and ethanol, and then forming the paste by doctor blade method.

(2) Next, after drying the green sheet at 80 °C for 5 hours, through holes for connecting the heating elements with external pins for conductor-filled through holes are provided by punching.

(3) A conductor containing paste A was prepared by mixing 100 parts by weight of tungsten carbide particle having the average particle diameter of 1 μm, 3.0 parts by weight of an acrylic binder, 3.5 parts by weight of an α-terpineol solvent, and 0.3 parts by weight of a dispersant.

A conductor containing paste B was also prepared by mixing 100 parts by weight of tungsten particle having the average particle diameter of 3 μm, 1.9 parts by weight of an acrylic binder, 3.7 parts by weight of an α-terpineol solvent, and 0.2 parts by weight of a dispersant.

Next, a lattice-shaped printing body for guard electrodes and a lattice-shaped printing body for ground electrodes were printed on the green sheet with the screen printing using the conductor containing paste A.

The through holes for conductor-filled through holes for connecting to terminal pins were also filled with the conductor containing paste B.

Moreover, such a printed green sheet 50 and green sheets not printed with a printed body were laminated in 50 sheets and integrated by pressure of 80 kgf/cm² at 130 °C to manufacture a lamination.

(4) Next, the obtained lamination was degreased at 600 °C for 5 hours in nitrogen gas and hot pressed at 1,890 °C for 3 hours under a pressure of 200 kgf/cm² to obtain an aluminum nitride plate-shaped body with the thickness of 3 mm. The obtained plate-shaped body was cut in circular shape with the diameter of 300 mm to obtain disk-shaped pieces having 230 mm-thickness to obtain plate-shaped bodies made of a ceramic. The size of each conductor-filled through hole was 0.2 mm-diameter and 0.2 mm-thickness.

The thickness of the guard electrodes 65 and the ground electrodes 66 was also 10 μm, the formed position of the guard electrodes was in 1 mm from the wafer-putting face, and the formed position of the ground electrodes was in 1.2 mm from the wafer-putting face. The length of one side of non-conductor formed area 66a among the guard electrodes 65 and the ground electrodes 66a was 0.5 mm.

(5) After grinding the plate-shaped body obtained from the above described (4) with a diamond grind stone, a mask was put and concave parts for thermocouples and grooves 67 (width: 0.5 mm, depth: 0.5 mm) for adsorbing the wafer are provided on the surface by blast treatment with Sic or the like.

(6) Furthermore, a layer for forming resistance heating elements 61 was printed on a face opposite to the wafer-putting face. A conductor containing paste was used for the printing. The conductor containing paste was Solbest PS 603D manufactured by Tokuriki Kagaku Kenkyuusho Co., Ltd., which is used for forming of conductor-filled through holes of a printed circuit board. The conductor containing paste was a silver/lead paste and contained 7.5 parts by weight of metal oxides comprising lead oxide, zinc oxide, silica, boron oxide, and alumina (each weight ratio thereof was 5/55/10/25/5) for 100 parts by weight of silver.

The shape of the silver was also scaly having the average particle diameter of 4.5 μm.

(7) The heater plate on which the conductor containing paste was printed was heated and fired at 780 °C to sinter the silver and lead in the conductor containing paste, and simultaneously to bake the paste on the ceramic substrate 63. The heater plate was further immersed in an electroless nickel plating bath of an aqueous solution containing 30 g /l of nickel sulfate, 30 g / l of boric acid, 30 g / l of ammonium chloride, and 60 g / l of Rochelle salt to deposit a nickel layer (not shown) containing not more than 1 % by weight of boron and having 1 μm-thickness on the surface of the silver sintered body 61. After that, the heater plate was annealed at 120 °C for 3 hours.

The heating elements of the silver sintered body had 5 μm-thickness, 2.4 mm-width, and 7.7 mΩ / □ of surface resistivity.

(8) On the face where the grooves 67 were formed, a titanium layer, a molybdenum layer, and a nickel layer were successively formed by sputtering. An equipment for sputtering was SV-4540 manufactured by ULVAC Japan Co., Ltd. The conditions of the sputtering were: pressure of 0.6 Pa, temperature of 100°C, electric power of 200 W, and the sputtering duration within a range from 30 seconds to 1 minutes, which is adjusted for respective metals.

The thickness of each obtained film was 0.3 μm for the titanium layer, 2 μm for the molybdenum layer, and 1 μm for the nickel layer based on the images obtained by a fluorescent x-ray analyzer.

(9) The ceramic plate obtained by the above described step (8) was immersed in an electroless nickel plating bath comprising an aqueous solution containing 30 g / l of nickel sulfate, 30 g / l of boric acid, 30 g / l of ammonium chloride, and 60 g / l of Rochelle salt to deposit a nickel layer (not shown) containing not more than 1 % by weight of boron and having 7 μm-thickness on the surface of the metal layers formed by sputtering, and then annealed at 120 °C for 3 hours.

The surface of resistance heating elements was not plated by the electrolytic nickel plating due to no current flow.

Further, the surface of the nickel plating layer was immersed in an electroless gold plating solution containing 2 g / l of gold potassium cyanide, 75 g/l of ammonium chloride, 50 g/l of sodium citrate, and 10 g/l of sodium hypophosphite at 93°C for 1 minute to form a gold plating layer having 1 μm-thickness on the nickel plating layer.

(10) Air suction holes 68 penetrating the plate to the back face from the grooves 67 were formed by drilling, and blind holes (not shown) were further provided to expose the conductor-filled through holes 16. The blind holes were connected with external terminal pins made of Kovar by using a gold brazing material of Ni-Au alloy (81.5 % by weight of Au, 18.4 % by weight of Ni and 0.1 % by weight of impurities) by heat reflow at 970°C. The external terminal pins made of Kovar were also formed on the resistance heating elements through a solder (tin 90 % by weight / lead 10 % by weight).

(11) Next, a plurality of thermocouples were buried in the concave parts for temperature control to obtain the wafer prober heater 501.

When the heater-equipped wafer prober was heated to 200°C, it reached to 200 °C in approximately 20 seconds.

Further, the breakdown voltage, the thermal conductivity, the degree of warping, the oxygen content, the leakage quantity, and the fracture toughness value of the ceramic substrate constituting the heater-equipped wafer prober were measured by the above described evaluation methods. The results were shown in the following Table 1. Further, the above described heater-equipped wafer prober was fitted in a supporting case and the cooling time was measured according to the above described method. The results were shown in Table 1.

(Example 12)

A green sheet of 0.50 mm-thickness was obtained by: employing a paste produced by mixing 100 parts by weight of a silicone nitride powder (the average particle diameter of 0.6 μm, produced by Tokuyama Corp.) fired at 500 °C for 1 hour in the air, 40 parts by weight of yttria (the average particle diameter: 0.4 μm), 20 parts by weight of alumina, 40 parts by weight of silica, 11.5 parts by weight of an acrylic binder, 0.5 parts by weight of a dispersant, and 53 parts by weight of alcohol containing 1-butanol and ethanol; and forming the paste by doctor blade method.

By using the green sheet, an electrostatic chuck was manufactured in the same manner as that of the processes (2) to (8) of the example 1, except that the sintering conditions were changed to be at the temperature of 1900 °C and the pressure of 200 kgf/cm².

The breakdown voltage, the degree of warping, the oxygen content, the leakage quantity and the fracture toughness value of the ceramic substrate of the obtained electrostatic chuck were measured by the above described evaluation methods. The results were shown in the following Table 1. The electrostatic chuck was also fitted in a supporting case and the cooling time was measured according to the above described method. The results were shown in the following Table 1.

(Comparative example 3)

An electrostatic chuck was manufactured in the same manner as that of example 7, except that the amount of yttria was changed to be 0.2 parts by weight.

The breakdown voltage, the thermal conductivity, the degree of warping, the oxygen content, the leakage quantity and the fracture toughness value of the ceramic substrate of the obtained electrostatic chuck were measured by the above described evaluation methods. The results were shown in the following Table 1. The electrostatic chuck was also fitted in a supporting case and the cooling time was measured according to the above described method. The results were shown in the following Table 1.

(Comparative example 4)

An electrostatic chuck was manufactured in the same manner as that of example 1, except that the firing temperature was changed to be at 1,600 °C and no pressure was applied.

The breakdown voltage, the thermal conductivity, the degree of warping, the oxygen content, the leakage quantity and the fracture toughness value of the ceramic substrate of the obtained electrostatic chuck were measured by the above described evaluation methods. The results were shown in the following Table 1. The electrostatic chuck also was fitted in a supporting case and the cooling time was measured according to the above described method. The results were shown in the following Table 1.

(Example 13)

An electrostatic chuck was manufactured in the same manner as that of example 1, except that the pressure application was carried out at 300 kgf / cm$^2$.

The breakdown voltage, the thermal conductivity, the degree of warping, the oxygen content, the leakage quantity, and the fracture toughness value of the ceramic substrate of the obtained electrostatic chuck were measured by the above described evaluation methods. The results were shown in the following Table 1. The electrostatic chuck was also fitted in a supporting case and the cooling time was measured according to the above described method. The results were shown in the following Table 1.

Table 1

| | oxygen (% by weight) | pressure (kgf/cm²) | leakage quantity (Pa·m³/sec) | breakdown voltage (kV/mm) | | | thermal conductivity (W/mK) | | fracture toughness (MPa·m^{1/2}) | warping degree (μm) | cooling time (sec) |
|---|---|---|---|---|---|---|---|---|---|---|---|
| | | | | 25°C | 200°C | 450°C | 25°C | 450°C | | | |
| example 1 | 1.6 | 150 | $1 \times 10^{-9}$ | 15 | 10 | 8 | 175 | 87 | 3.8 | 2 | 30 |
| example 2 | 1.6 | 100 | $3 \times 10^{-9}$ | 15 | 10 | 8 | 175 | 87 | 3.7 | 2 | 30 |
| example 3 | 1.6 | 80 | $5 \times 10^{-9}$ | 14 | 10 | 7 | 170 | 85 | 3.7 | 3 | 28 |
| example 4 | 1.6 | 70 | $8 \times 10^{-9}$ | 14 | 5 | 3 | 170 | 85 | 3.7 | 5 | 30 |
| example 5 | 1.6 | 50 | $8 \times 10^{-9}$ | 13 | 5 | 2 | 170 | 85 | 3.7 | 5 | 32 |
| example 6 | 1.6 | 0 | $8 \times 10^{-8}$ | 10 | 5 | 1 | 160 | 80 | 3.0 | 5 | 35 |
| example 7 | 1.6 | 200 | $1 \times 10^{-10}$ | 20 | 15 | 10 | 180 | 90 | 3.5 | 1 | 25 |
| example 8 | 1.6 | 200 | $1 \times 10^{-10}$ | 20 | 15 | 10 | 180 | 90 | 3.5 | 1 | 25 |
| example 9 | 1.6 | 200 | $1 \times 10^{-10}$ | 20 | 15 | 10 | 180 | 90 | 3.5 | 1 | 25 |
| example 10 | 1.6 | 200 | $1 \times 10^{-10}$ | 20 | 15 | 10 | 180 | 90 | 3.5 | 1 | 25 |
| example 11 | 1.6 | 200 | $1 \times 10^{-10}$ | 20 | 15 | 10 | 180 | 90 | 3.5 | 1 | 25 |
| example 12 | 2.5 | 200 | $2 \times 10^{-10}$ | 20 | 15 | 10 | – | – | 7.0 | 1 | 25 |
| example 13 | 1.6 | 300 | $8 \times 10^{-13}$ | 20 | 15 | 10 | 170 | 50 | 3.0 | 1 | 40 |
| comparative example 1 | 1.6 | 150 | $8 \times 10^{-6}$ | 2 | 0.8 | 0.4 | 140 | 40 | 2.8 | 10 | 45 |
| comparative example 2 | <0.05 | 150 | $1 \times 10^{-6}$ | 2 | 0.5 | 0.1 | 140 | 40 | 2.8 | 10 | 45 |
| comparative example 3 | <0.05 | 200 | $5 \times 10^{-6}$ | 2 | 0.6 | 0.3 | 140 | 40 | 2.8 | 10 | 50 |
| comparative example 4 | 1.6 | 0 | $5 \times 10^{-6}$ | 2 | 0.5 | 0.1 | 140 | 40 | 2.8 | 10 | 60 |

As being made clear from the results of Table 1, since the ceramic substrates constituting the electrostatic chucks and the wafer prober according to the examples 1 to 13 all had $10^{-7}$ Pa · m³/sec or less of the leakage quantity of helium measured by the helium leakage detector, their breakdown voltage values were all found high and the temperature rising/falling property was also excellent and the degrees of warping were low values. On the other hand, since the ceramic substrates of the electrostatic chucks of the comparative examples 1 to 4 had leakage quantity of helium exceeding $10^{-7}$ Pa · m$^3$ / sec, their breakdown voltage values were considerably low and the temperature rising/falling property was also inferior and the degrees of warping were significant and any result was found inferior to those of the examples 1 to 13.

As described above, since the ceramic substrate of the present invention is sintered so as to have the leakage quantity as low as $10^{-7}$ Pa · m$^3$/sec (He) or less by measurement with the helium leakage detector, the degree of dropping of the thermal conductivity at a high temperature is slight. The breakdown voltage at a high temperature is also high. Further, the degree of warping is slight. Further, the cooling time is short: this fact is supposedly due to that a gas used as a coolant is prevented from leaking out from these ceramics.

On the other hand, if the leakage quantity is lowered to $10^{-13}$ Pa · m$^3$/sec (He) or less , the degree of the drop of the thermal conductivity is, to the contrary, increased and the fracture toughness is also lowered. Although the reason for that is not clear, it is supposed that if densification proceeds too far, oxygen in the grain boundaries is diffused into the ceramic crystals and thus deteriorates the crystallinity and further, it is also supposed that barriers in the grain boundaries are lowered to result in easy expansion of cracks. Further, the cooling speed is also lowered. That is supposedly due to the fact that gas cannot penetrate inside the ceramics and thus cannot take heat to result in the decrease of the cooling speed.

Industrial Applicability

As described above, the ceramic substrate of the present invention is sintered so as to have a leakage amount of as low as $10^{-7}$ Pa · m$^3$/sec (He) or less by measurement with the helium leakage detector, so that the ceramic substrate is excellent in the temperature rising/falling property, has a high breakdown voltage at a high temperature and a small warping degree and therefore suitable to be used for a device for producing and examining a semiconductor.

**Claims**

1. A ceramic substrate having a conductor on a surface or inside thereof,
   wherein said ceramic substrate has a leakage quantity of $10^{-7}$ Pa · m$^3$/sec (He) or less by measurement with a helium leakage detector.

Fig.1

14 Bottomed hole

12      12

12

10 Ceramic heater

15 Through
   hole

12 Resistance
   heating
   element

14

14

14

14

13 External
   terminal

15

14

14      14

11 Ceramic
   substrate

Fig.2

10

9 Silicon
  wafer

26
Supporting
pin

12

11a
Wafer
treating
surface

11

14

11b Bottom
surface  15

13

19

12

19 Conductor filled
   through hole

13

Fig.3

101 Electrostatic chuck

2 Chuck positive electrostatic layer

3 Chuck negative electrostatic layer

4 Ceramic dielectric film

5 Resistance heating element

Fig.4

Fig.5

Fig.6

Fig.7

Fig.8

(a)

(b)

(c)

(d)

Fig.9

Fig.10

Fig.11

Fig.12

Fig.13

## INTERNATIONAL SEARCH REPORT

| | International application No. |
|---|---|
| | PCT/JP01/01941 |

A. CLASSIFICATION OF SUBJECT MATTER
　　Int.Cl⁷　C04B35/00

According to International Patent Classification (IPC) or to both national classification and IPC

B. FIELDS SEARCHED

Minimum documentation searched (classification system followed by classification symbols)
　　Int.Cl⁷　C04B35/00-599, H01L21/68, H01L23/15, H05B3/14

Documentation searched other than minimum documentation to the extent that such documents are included in the fields searched
　　Jitsuyo Shinan Koho　　　　1926-1996　　　Toroku Jitsuyo Shinan Koho　1994-2001
　　Kokai Jitsuyo Shinan Koho　1971-2001　　　Jitsuyo Shinan Toroku Koho　1996-2001

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP, 2000-63177, A (NGK INSULATORS, LTD.), 29 February, 2000 (29.02.00), Claims; Column 2, lines 32 to 33; Column 3, line 18 (Family: none) | 1 |
| X | JP, 11-343168, A (Kyocera Corporation), 14 December, 1999 (14.12.99), Par. Nos. [0026] to [0027] & DE, 19849340, A1 | 1 |
| X | JP, 11-209171, A (Kyocera Corporation), 03 August, 1999 (03.08.99), Par. Nos. [0021] to [0023] & DE, 19849340, A1 | 1 |
| X | JP, 6-219850, A (Asahi Glass Co., Ltd.), 09 August, 1994 (09.08.94), Par. No. [0022]　　(Family: none) | 1 |

☐ Further documents are listed in the continuation of Box C.　　☐ See patent family annex.

| * Special categories of cited documents: | "T" later document published after the international filing date or |
|---|---|
| "A" document defining the general state of the art which is not considered to be of particular relevance | priority date and not in conflict with the application but cited to understand the principle or theory underlying the invention |
| "E" earlier document but published on or after the international filing date | "X" document of particular relevance; the claimed invention cannot be considered novel or cannot be considered to involve an inventive |
| "L" document which may throw doubts on priority claim(s) or which is cited to establish the publication date of another citation or other special reason (as specified) | step when the document is taken alone "Y" document of particular relevance; the claimed invention cannot be considered to involve an inventive step when the document is |
| "O" document referring to an oral disclosure, use, exhibition or other means | combined with one or more other such documents, such combination being obvious to a person skilled in the art |
| "P" document published prior to the international filing date but later than the priority date claimed | "&" document member of the same patent family |

| Date of the actual completion of the international search | Date of mailing of the international search report |
|---|---|
| 12 April, 2001 (12.04.01) | 24 April, 2001 (24.04.01) |

| Name and mailing address of the ISA/ | Authorized officer |
|---|---|
| Japanese Patent Office | |
| Facsimile No. | Telephone No. |

Form PCT/ISA/210 (second sheet) (July 1992)